Europäisches Patentamt

(19) European Patent Office

Office européen des brevets

(11) Numéro de publication: **0 167 055**
**A1**

(12) **DEMANDE DE BREVET EUROPEEN**

(21) Numéro de dépôt: **85107523.4**

(22) Date de dépôt: **18.06.85**

(51) Int. Cl.⁴: **H 03 H 9/05**
**G 04 F 5/06**

(30) Priorité: **22.06.84 FR 8410014**

(43) Date de publication de la demande:
**08.01.86 Bulletin 86/2**

(84) Etáts contractants désignés:
**CH DE GB LI NL**

(71) Demandeur: **Eta SA Fabriques d'Ebauches**
**Schild-Rust-Strasse 17**
**CH-2540 Granges(CH)**

(72) Inventeur: **Lambert, Roger**
**Chemin du Joran 8**
**CH-2000 Neuchâtel(CH)**

(72) Inventeur: **Bron, Alphonse**
**Rue des Sports**
**CH-2854 Bassecourt(CH)**

(74) Mandataire: **Barbeaux, Bernard et al,**
**SMH Société Suisse de Microélectronique et**
**d'Horlogerie S.A. Département Brevets et Licences 6,**
**Faubourg du Lac**
**CH-2501 Bienne(CH)**

(54) **Ensemble comprenant un résonateur piézo-électrique encapsulé et un circuit intégré associé.**

(57) L'invention concerne les résonateurs piézo-électriques, notamment à quartz, et les circuits électroniques associés à ces résonateurs.

L'ensemble selon l'invention comprend un résonateur (2) encapsulé dans un boîtier tubulaire (1) formé d'un capot (4), d'une embase (5) et de deux broches conductrices (6a, 6b) qui traversent cette dernière pour relier électriquement le résonateur à l'extérieur du boîtier, et un circuit intégré (12) monté sur les extrêmités externes (9a, 9b) des broches, qui comprend au moins un circuit d'entretien pour faire vibrer le résonateur. De préférence l'ensemble comprend également un élément tubulaire de protection (10) qui prolonge le capot, entoure le circuit intégré et dont l'intérieur est rempli d'un matériau isolant durcissable (18).

L'ensemble peut être utilisé pour la réalisation de pièces d'horlogerie ou d'appareils de mesure de grandeurs physiques comme la température ou la pression dans un gaz.

./...

Fig.1

## ENSEMBLE COMPRENANT UN RESONATEUR PIEZO-ELECTRIQUE ENCAPSULE ET UN CIRCUIT INTEGRE ASSOCIE

La présente invention a pour objet un ensemble comprenant un résonateur piézo-électrique encapsulé et un circuit intégré associé à ce résonateur.

Lorsque l'idée de réaliser une montre électronique en utilisant comme base de temps un oscillateur à quartz est apparue, les fabricants de montres ou de mouvements ont été obligés de mettre au point eux-mêmes des résonateurs de très petite dimension pouvant convenir à ce genre d'application et de trouver des méthodes pour les fabriquer en grandes séries et de manière que leur prix de revient soit le plus bas possible. En réalité seuls quelques-uns de ces fabricants se sont effectivement mis à produire ces résonateurs pour leur propre compte et pour les vendre aux autres. Les méthodes de fabrication n'ont ensuite pas cessé d'évoluer dans le sens de l'automatisation ainsi que de la miniaturisation et de la baisse du coût des produits.

En ce qui concerne les circuits intégrés qui devaient être associés aux résonateurs à quartz, ceux-ci ont, au départ, surtout été étudiés et fabriqués par d'importantes firmes spécialisées en électronique. Par la suite, en raison du développement rapide des circuits intégrés en général, ces sociétés se sont désintéressées des circuits horlogers qui n'auraient plus représenté qu'une très faible part de leur chiffre d'affaire et qui, au regard des autres, devenaient des circuits spéciaux. La production de ces circuits horlogers a donc été reprise par les fabricants de montres eux-mêmes et accessoirement par quelques sociétés d'élecronique de moindre importance que les précédentes.

D'autre part, grâce à leur expérience, les producteurs de résonateurs horlogers ont pu mettre au point et fabriquer d'autres résonateurs d'aussi petite dimension, de prix pratiquement aussi bas et qui trouvent des applications en dehors de l'horlogerie. Il s'agit par exemple de résonateurs plus stables que ceux utilisés habituellement dans les montres et qui peuvent servir notamment à la réalisation de générateurs de fréquence de référence ou, à l'opposé, de résonateurs très sensibles aux variations de certaines grandeurs physiques comme la température ou la pression et qui peuvent jouer le rôle de capteurs pour des appareils de mesure de ces grandeurs.

Pour ces applications non horlogères le fait qu'il y ait d'un côté des fabricants de résonateurs seuls et, de l'autre, des fabricants de circuits intégrés qui ne se préoccupent pas des cas particuliers mais au contraire s'arrangent pour que leurs produits aient un caractère universel, pose des problèmes.

Par exemple, pour réaliser un thermomètre à quartz il faut au moins un oscillateur de mesure avec un résonateur encapsulé et un circuit d'entretien associé à ce résonateur, un générateur de fréquence de référence, un circuit de comparaison pour produire, à partir des signaux fournis par l'oscillateur de mesure et le générateur, un signal représentatif de la température et enfin des moyens pour afficher, par exemple numériquement, cette température. Le générateur de fréquence de référence peut être lui aussi constitué par un oscillateur à quartz mais cela n'est pas obligatoire. Il peut s'agir également d'un compteur de fréquence de laboratoire, d'une base de temps de microprocesseur ou de toute autre source capable de fournir un signal de fréquence fixe et convenable.

D'autre part, il est pratiquement toujours nécessaire de faire appel à des diviseurs pour diminuer la fréquence du signal fourni par l'oscillateur de mesure et éventuellement celui du générateur de fréquence de référence afin que ces signaux puissent être traités par le comparateur.

La personne qui veut effectivement réaliser un tel thermomètre pourra se procurer par exemple, en plus du résonateur à quartz servant de capteur, un dispositif d'affichage numérique du genre LED ou LCD, un circuit logique de type CMOS ou TTL capable de jouer le rôle à la fois de comparateur et de circuit de commande du dispositif d'affichage, des diviseurs de fréquence et enfin un générateur de fréquence de référence à condition que celui-ci ne soit pas aussi un oscillateur à quartz.

Par contre, ce qu'elle ne trouvera pas tout fait c'est le circuit d'entretien du résonateur de mesure et elle sera obligée de le faire elle-même avec des composants discrets. De plus, si pour une raison quelconque, elle était amenée à opter pour la solution de l'oscillateur à quartz comme générateur de fréquence de référence ce ne serait plus un mais deux circuits d'entretien qu'elle devrait construire et il se pourrait très bien que ceux-ci aient besoin d'être différents. Enfin, il n'est pas dit que cette personne soit capable de concevoir elle-même ce ou ces circuits et qu'elle ne soit pas obligée de trouver quelqu'un d'autre pour le faire, ce qui augmenterait dans une large mesure le prix de revient de son appareil.

Naturellement, la situation serait la même si la personne voulait réaliser un appareil pour mesurer une grandeur physique différente de la température ou tout autre dispositif utilisant un ou plusieurs résonateurs à quartz.

Il serait donc très intéressant pour elle que celui qui fabrique des résonateurs ne les vende pas seuls mais accompagnés chacun d'un circuit pour le faire vibrer et pour fournir un signal qui peut être appliqué directement à des circuits électroniques standards du commerce.

Par ailleurs il est bien clair que, pour des questions de parasites et d'atténuation de signal, un résonateur ne peut pas être placé très loin de son circuit d'entretien. Or, dans le cas d'un instrument de mesure de température, pression ou autre, il est fréquent que l'élément sensible soit placé à grande distance, par exemple plusieurs mètres ou plusieurs dizaines de mètres, du reste de l'appareil. Donc, dans le cas où le résonateur est un capteur, le mieux pour l'utilisateur serait de pouvoir se procurer un ensemble compact résonateur-circuit, en somme une sonde, qu'il pourrait à volonté monter directement sur un circuit imprimé d'appareil ou fixer au bout d'un câble de transmission coaxial ou bifilaire.

En fait la question de réaliser un ensemble résonateur-circuit intégré de ce genre a déjà été envisagée en horlogerie et une solution a même été proposée.

Cette solution qui fait l'objet de la demande de brevet japonaise publiée le 7 octobre 1981 sous le numéro 56-128 482 concerne naturellement les résonateurs en forme de diapason puisque ce sont ceux-là qui sont utilisés pour constituer les bases de temps des pièces d'horlogerie. Elle consiste tout simplement à placer le circuit intégré nu, c'est-à-dire ni encapsulé ni enrobé, sur la base du diapason, le tout étant bien entendu placé dans un boîtier étanche. Les plots de connexion du circuit intégré, plus connus sous le nom anglais de "bumps", sont soudés sur des métallisations que porte la base du diapason, ce qui permet d'assurer une liaison à la fois mécanique et électrique entre les deux éléments. Certaines de ces métallisations sont les prolongements de celles qui sont prévues sur les branches du diapason pour pouvoir le faire vibrer. Sur d'autres sont collées ou soudées les extrémités de conducteurs qui traversent le boîtier et qui servent non seulement à assurer la liaison électrique entre le circuit intégré et l'extérieur de ce boîtier mais aussi à supporter l'ensemble diapason-circuit.

Lorsqu'elle peut être utilisée, c'est-à-dire lorsque le circuit intégré ne comporte qu'un nombre assez limité de bornes d'entrée et de sortie, ce qui est par exemple le cas pour une montre analogique prévue pour indiquer seulement l'heure et éventuellement la date et où les corrections se font mécaniquement, cette solution présente des avantages par rapport à la méthode qui consiste actuellement à fabriquer séparément le résonateur encapsulé et le circuit intégré pour les monter ensuite sur un circuit imprimé ou sur un support équivalent comme une grille surmoulée. Tout d'abord ce circuit imprimé ou ce support est plus simple car il n'y a plus de connexion à prévoir entre le résonateur et le circuit intégré. D'autre part, le montage de ce dernier est supprimé. Il y a seulement un peu plus de points de soudure ou de collage à faire pour fixer l'ensemble sur le support que si le boîtier ne contenait que le diapason mais cela n'est pas très gênant. Enfin, si auparavant on faisait appel à un circuit intégré encapsulé, les opérations d'encapsulage sont elles aussi supprimées.

Malheureusement la solution en question présente aussi des inconvénients qui font qu'elle ne permet pas dans tous les cas de résoudre les problèmes exposés ci-dessus, que rencontrent les utilisateurs de résonateurs non horlogers. En premier lieu il a été constaté que, pour un diapason vibrant en torsion, la présence du circuit intégré sur la base perturbait le fonctionnement du résonateur. Or c'est précisément de cette manière que vibrent les quartz thermomètres miniatures produits actuellement. De plus, pour la même raison, elle ne convient pas pour toutes les formes de résonateurs, par exemple pour des barreaux. Enfin, on a constaté également que lorsque l'on prévoit un boîtier en verre et que l'on procède à la mise à la fréquence du résonateur par laser, le fonctionnement du circuit est affecté, ce qui ne permet pas d'effectuer un réglage correct.

Le but de l'invention est de fournir une autre solution aux mêmes problèmes mais qui ne présente pas ces défauts.

Ce but est atteint grâce au fait que dans le cas de l'ensemble selon l'invention qui comprend un résonateur piézo-électrique, un boîtier tubulaire contenant le résonateur et comportant une embase, un capot et deux broches conductrices traversant cette embase et ayant chacune une extrémité interne en liaison électrique avec le résonateur et une extrémité externe; et un circuit intégré muni de plots de connexion d'entrée et de sortie dont deux sont reliés électriquement et respectivement aux broches conductrices, ce circuit intégré est placé au voisinage de l'embase du boîtier et monté sur les extrémités externes des broches conductrices.

De préférence l'ensemble comprend en plus un élément tubulaire de protection solidaire du boîtier du résonateur, situé dans le prolongement du capot et à l'intérieur duquel est placé le circuit intégré.

Par ailleurs, le capot et l'embase du boîtier peuvent avantageusement être réalisés en verre et soudés ensemble par fusion. Dans ce cas, il y a tout intérêt à ce que l'élément de protection soit également en verre et fait d'une seule pièce avec le capot.

Toutefois, pour certaines applications, il peut être préférable de prévoir un capot et un élément de protection métalliques.

En outre, pour des questions de fabrication, le mieux est que les extrémités externes des broches conductrices ne soient pas fixées directement sur les plots de connexion du circuit intégré prévus pour être reliés au résonateur, mais par l'intermédiaire de pattes de connexions internes ayant chacune une extrémité soudée sur l'un des plots et une autre sur laquelle est par exemple collée avec une colle conductrice l'extrémité de l'une des broches.

De plus il est très souvent nécessaire que l'ensemble comporte également des pattes de connexion externes soudées sur les plots du circuit intégré autres que ceux reliés au résonateur et qui sortent de l'élément tubulaire du côté opposé à celui du boîtier.

Enfin il y a intérêt, pour améliorer la protection du circuit et des autres parties de l'ensemble qui sont entourés par l'élément tubulaire, à remplir l'intérieur de ce dernier d'un matériau durcissable isolant, par exemple d'une colle epoxy, qui, dans certains cas, peut servir également de moyen de scellement pour le boîtier du résonateur et/ou de fixation de l'élément tubulaire sur ce boîtier, et qui, lorsque cet élément est en verre, doit aussi, le plus souvent, être opaque pour protéger le circuit contre la lumière.

D'autres caractéristiques et avantages de l'invention apparaîtront plus clairement à la lecture de la description qui suit de plusieurs modes possibles de mise en oeuvre donnés à titre d'exemples non limitatifs. Cette description se réfère au dessin annexé sur lequel:

- la figure 1 représente, vue en coupe longitudinale, une forme préférée de réalisation de l'ensemble selon l'invention;

- la figure 2 est une vue en coupe longitudinale selon le plan II-II de la figure 1;

- les figures 3 et 4 montrent respectivement, toujours vues en coupe longitudinale, une autre forme possible de réalisation de l'ensemble selon l'invention et une variante de celle-ci;  et

- la figure 5 représente, vu de la même façon, un troisième mode d'exécution.

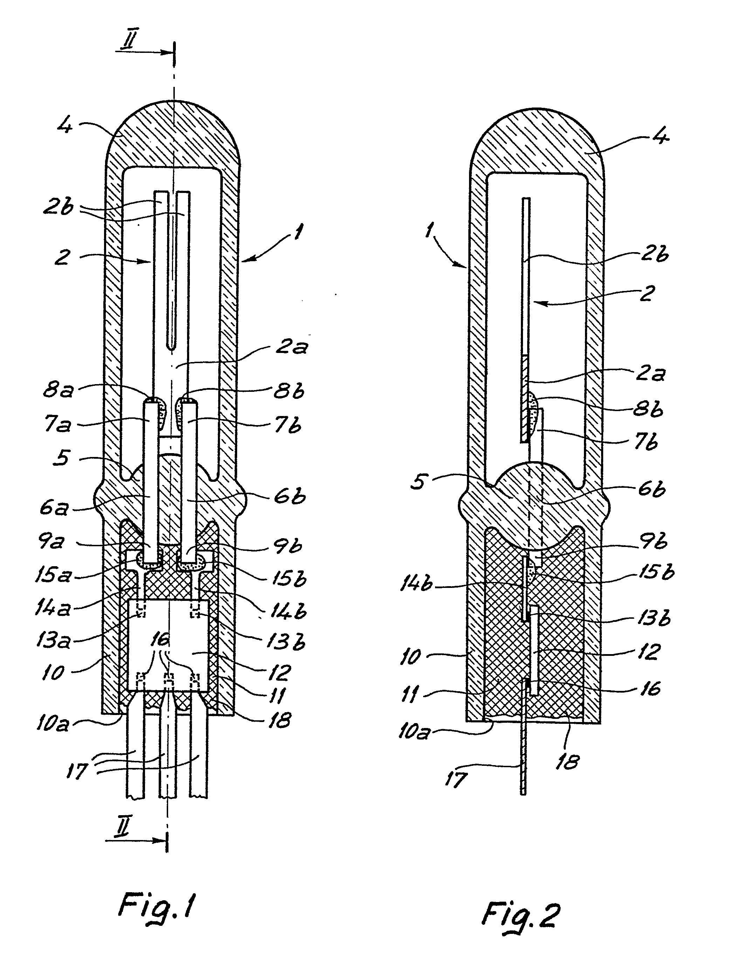

Tel qu'il est représenté sur les figures 1 et 2 l'ensemble selon l'invention comprend un boîtier tubulaire 1 dans lequel est enfermé sous vide ou sous atmosphère de gaz inerte un résonateur 2, comprenant un diapason en quartz dont la base $2_a$ et les branches $2_b$ portent des métallisations qui permettent de le soumettre à des champs électriques pour le faire vibrer selon un mode déterminé.

Ces métallisations n'ont pas été représentées sur le dessin car leur forme et leur disposition dépendent des caractéristiques du diapason et de la façon dont il doit osciller. Or le résonateur 2 peut être aussi bien un résonateur horloger classique prévu pour vibrer en flexion, à une fréquence d'environ 32 kHz, qu'un résonateur conçu pour servir de capteur de température comme celui qui est décrit dans la demande de brevet européen publiée sous le numéro 0 048 689, ou que tout autre résonateur de même forme devant nécessairement ou de préférence être placé dans un boîtier étanche.

Le boîtier 1 comprend un capot 4 en verre, soudé par fusion sur une embase 5 également en verre. Cette embase 5 qui a la forme d'une bille est traversée par deux broches conductrices $6_a$, $6_b$, isolées électriquement l'une de l'autre et dont les extrémités internes $7_a$, $7_b$ sont fixées par de petits amas de colle conductrice $8_a$, $8_b$ sur les métallisations non représentées que porte la base $2_a$ du diapason. Ces broches $6_a$, $6_b$, qui ne sont en fait que des fils de petit diamètre, réalisés en un matériau capable de très bien adhérer au verre et ayant pratiquement le même coefficient de dilatation que ce dernier, ce qui est le cas par exemple pour l'alliage de fer, de nickel et de cobalt connu sous la marque "KOVAR", ont naturellement pour rôle d'assurer la liaison électrique entre l'extérieur du boîtier et le résonateur 2 mais ils servent également d'unique support pour ce dernier.

Contrairement à ce qui se passe habituellement pour les boîtiers tubulaires de résonateurs en général, c'est-à-dire pas seulement ceux en verre, le capot 4 n'est pas formé par la totalité mais par une partie seulement d'un tube qui se prolonge en fait bien au-delà de l'embase 5 et même des extrémités externes $9_a$, $9_b$ des broches conductrices $6_a$, $6_b$.

La partie 10 de ce tube qui prolonge le capot 4 entoure un espace 11, dans lequel est logé un circuit intégré 12 à l'état de puce, c'est-à-dire ni enrobé ni encapsulé. Ce circuit 12 présente naturellement un certain nombre de plots de connexion d'entrée et de sortie.

Deux de ces plots qui portent les références $13_a$ et $13_b$ sur le dessin et qui se trouvent de préférence du côté de l'embase 5 sont destinés à être reliés au résonateur. Cette liaison est réalisée par l'intermédiaire de pattes de connexion $14_a$, $14_b$, qui sont soudées par exemple par thermo-compression sur les plots $13_a$ et $13_b$ et sur lesquelles sont fixées par des points de colle conductrice $15_a$, $15_b$ les extrémités $9_a$, $9_b$ des broches $6_a$, $6_b$.

D'autre part, sur les autres plots de connexion du circuit 12 qui portent tous la référence 16 sont également soudées des pattes de connexion 17 qui, elles, se prolongent au-delà de l'extrémité évidemment ouverte $10_a$ de la partie 10 du tube en verre et qui pourront être fixées par exemple sur un circuit imprimé d'appareil ou aux extrémités des conducteurs d'un câble de transmission.

Enfin toute la partie restante de l'espace 11 est remplie par un matériau durcissable 18, isolant et opaque, tel qu'une résine epoxy, ce qui assure une protection complète du circuit intégré 12, y compris contre la lumière. Par ailleurs, ceci permet également d'immobiliser le circuit, les extrémités des pattes de connexion 16, les pattes de connexion internes $14_a$ et $14_b$ ainsi que les extrémités $9_a$, $9_b$ des broches $6_a$, $6_b$, et, par conséquent, d'éviter les risques de rupture des liaisons de ces différentes parties entre elles, qu'il s'agisse de points de collage ou de soudure.

Naturellement le nombre de plots 16 et de pattes 17 dépend de l'utilisation pour laquelle l'ensemble est prévu et de ce que contient le circuit intégré 12. La figure 1 en montre trois mais il peut y en avoir plus ou moins.

Par exemple, si l'ensemble est destiné à équiper une montre analogique à correction mécanique, le circuit intégré 12 comprendra le circuit d'entretien du résonateur 2, une chaîne de division de fréquence, un circuit de mise en forme d'impulsions et un circuit d'alimentation en courant du moteur pas à pas. Dans ce cas il faudra donc quatre plots 16 et autant de pattes de connexion 17. Deux de ces pattes seront reliées aux bornes de la pile qui équipe la montre et les deux autres à la bobine du moteur.

Si, par contre, l'ensemble est prévu pour la réalisation d'un thermomètre le circuit intégré 12 pourrait ne comprendre que le circuit d'entretien du résonateur. Toutefois, dans l'intérêt de l'utilisateur, il sera souvent préférable d'ajouter, à la suite de ce dernier, d'autres circuits, par exemple un amplificateur d'isolation, un certain nombre d'étages de division de fréquence et un circuit tampon. Dans tous les cas le nombre de plots 16 et de pattes de connexion 17 pourra être limité à trois. L'une des pattes servira à transmettre le signal de sortie du circuit 12, dont la fréquence sera représentative de la température, et les deux autres à relier ce circuit à une source de tension d'alimentation.

Une solution plus avantageuse, surtout si le capteur doit être placé au bout d'un câble, consiste à prévoir en plus dans le circuit 12 des moyens pour superposer le signal de sortie à la tension d'alimentation car il n'y a plus alors besoin que de deux plots 16 et deux pattes 17. Bien entendu il faudra également prévoir dans le reste du thermomètre d'autres moyens pour récupérer ce signal de sortie mais ceux-ci peuvent être très simples à réaliser et leur conception est sans commune mesure avec celle d'un circuit d'entretien de résonateur.

Sous la forme d'exécution qui vient d'être décrite l'ensemble selon l'invention se prête bien à une fabrication largement automatisée et en grande série.

On peut par exemple partir d'un ruban métallique mince, prédécoupé de façon à présenter un grand nombre d'ouvertures identiques et à l'intérieur de chacune desquelles débordent des languettes de forme convenable. Certaines de ces languettes formeront les pattes de connexion 17, deux autres les pattes $14_a$ et $14_b$ et d'autres encore serviront à supporter temporairement le résonateur 2.

Les premières opérations consistent à positionner sur la bande le résonateur et le circuit intégré et à souder par thermocompression, sur les plots de connexion de ce dernier, les extrémités des languettes prévues à cet effet. Puis on met la pièce constituée par l'embase 5 et les broches $6_a$, $6_b$, qui a été produite séparément et on colle les extrémités de ces broches, au moyen d'une colle conductrice, d'une part sur les languettes dont font partie les pattes de connexion internes $14_a$, $14_b$, et, d'autre part, sur la base du résonateur.

On libère ensuite le tout du ruban métallique en coupant au bon endroit toutes les languettes sauf celles qui servaient à porter le résonateur et on enfile ce tout dans un tube en verre de longueur adéquate.

L'ensemble presque terminé est alors placé dans une enceinte où règne le vide ou qui contient un gaz inerte et on procède à la soudure par fusion de l'embase 5 et du tube en faisant de préférence appel au procédé décrit dans la demande de brevet suisse déposée le 24 juin 1983 sous le numéro 3 456/83, c'est-à-dire en utilisant comme moyen de chauffage un faisceau laser focalisé sur la zone de soudure.

Il ne reste plus ensuite qu'à remplir l'espace 11 avec le matériau isolant et durcissable choisi, cette opération se faisant naturellement à l'air libre.

Il est clair que, rien que pour cette première forme d'exécution, il peut exister de nombreuses variantes.

Par exemple le collage des extrémités des broches $6_a$ et $6_b$ sur les pattes de connexion internes $14_a$, $14_b$ et sur la base du résonateur pourrait être remplacé par un soudage avec apport ou un soudage électrique par point.

L'embase 5 pourrait ne pas avoir une forme sphérique mais cylindrique, conique ou autre.

Les pattes de connexion $14_a$ et $14_b$, qui ne sont en fait que des intermédiaires tant du point de vue mécanique qu'électrique, pourraient être supprimées et les extrémités externes des broches $6_a$, $6_b$ directement soudées sur les plots $13_a$, $13_b$ du circuit intégré. Dans ce cas les broches devraient, de préférence, être en forme de bandes et non pas de fils.

Par ailleurs, il serait possible de remplacer le soudage par fusion de l'embase et du capot du résonateur par un collage. On pourrait même alors envisager d'effectuer en une seule opération le scellement du boîtier du résonateur et le remplissage par un matériau durcissable de l'espace 11 dans lequel est logé le circuit intégré, à condition naturellement de pouvoir trouver une colle à la fois opaque à la lumière et capable d'assurer une très bonne étanchéité du boîtier 1.

Il y aurait aussi la possibilité, tout en conservant les pattes de connexion $14_a$ et $14_b$ pour le résonateur, de ne pas remplir l'espace 11, mais de seulement enrober le circuit intégré et les extrémités soudées sur ce dernier de toutes les pattes de connexion d'un matériau durcissable et opaque, l'opération d'enrobage s'effectuant avant celle de collage des extrémités de broches.

D'autre part, on pourrait également réaliser l'ensemble en partant d'un résonateur encapsulé sous verre tel qu'il en existe actuellement, en fixant le circuit intégré déjà muni de ses pattes de connexion aux extrémités des broches de connexion dont est forcément muni le boîtier du résonateur, en plaçant ensuite autour du circuit un tube de verre ouvert à ses deux extrémités, ayant ou non le même diamètre que le capot du boîtier, et en fixant ce tube sur le boîtier par un moyen adéquat, ce moyen pouvant être le matériau de remplissage 18.

En fait toutes ces modifications qui viennent d'être envisagées, qui ne sont pas les seules possibles et dont certaines pourraient être apportées en même temps, ne feraient que compliquer la fabrication de l'ensemble et rendre celui-ci moins fiable, notamment pour des questions d'étanchéité et/ou de fragilité.

Un gros avantage des boîtiers en verre est qu'ils permettent d'effectuer une mise à la fréquence du résonateur qu'ils contiennent en agissant directement sur celui-ci au moyen d'un faisceau laser. On peut alors, dans beaucoup de cas, se dispenser de prévoir dans le circuit d'entretien du résonateur une capacité variable de réglage qui, à quelques exceptions près, ne peut pas être intégrée avec les autres éléments du circuit, et la remplacer par une capacité fixe qui, elle, est facilement intégrable.

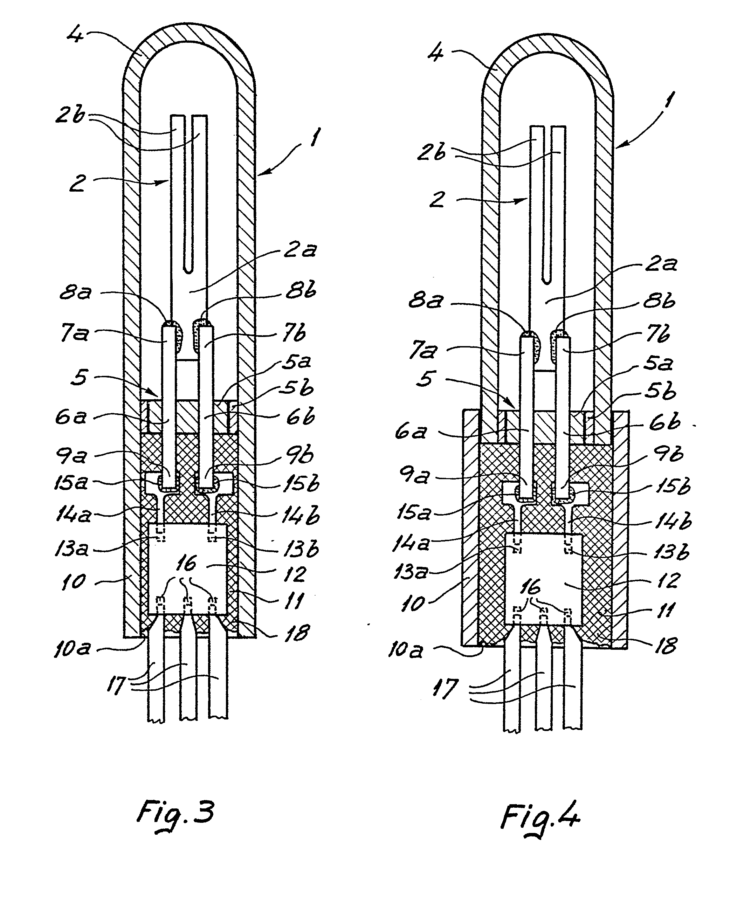

Donc, pour tous les usages où l'ensemble selon l'invention ne risquera pas de subir des chocs ou des pressions extérieures relativement importantes il pourra se présenter sous la forme d'exécution qui vient d'être décrite. Toutefois, si tel n'est pas le cas, il pourra s'avérer parfois plus intéressant de le réaliser sous la forme représentée à la figure 2 ou sous celle montrée à la figure 4, la seconde n'étant en fait qu'une variante de la première.

Sur ces figures 3 et 4 les éléments identiques ou correspondant à ceux des figures 1 et 2 portent les mêmes repères.

Ce qui différencie le mode de réalisation de la figure 3 du précédent c'est que:

1. le tube qui forme le capot 4 et l'élément tubulaire de protection qui abrite le circuit intégré 12 n'est plus en verre mais métallique et réalisé en un alliage tel que le laiton ou le maillechort;

2. l'embase 5 du boîtier est adaptée à un capot métallique et comprend une partie cylindrique centrale $5_a$ en verre, que traversent les broches de connexion $6_a$ et $6_b$ et qui est entourée par un anneau métallique réalisé par exemple en "KOVAR";

3. le tube formant le capot 4 et son prolongement 10 n'est plus soudé par fusion sur l'embase mais chassé sur celle-ci.

En fait ce chassage du tube sur l'embase risque de poser des problèmes pour deux raisons : d'une part, l'embase 5 doit être enfoncée assez profondément dans le tube; d'autre part, la présence du circuit intégré 12 déjà fixé aux extrémités des broches $6_a$, $6_b$ peut rendre l'opération encore plus difficile.

Une solution consisterait à donner à la partie 10 du tube qui prolonge le capot du boîtier une forme légèrement conique, la base du cône se trouvant naturellement du côté de l'extrémité ouverte $10_a$ du tube. Ceci permettrait d'amener sans résistance l'embase avec tout ce qu'elle porte (résonateur, broches et pattes de connexion, circuit intégré) jusqu'à une position avancée à partir de laquelle s'effectuerait véritablement l'opération de chassage. A noter que la forme donnée à l'extrémité fermée du tube sur la figure correspond à une fabrication par emboutissage. Si cette dernière était faite par perçage d'un trou borgne dans un cylindre métallique, il suffirait de donner une forme conique à la paroi interne de la partie 10 du tube.

Une autre possibilité serait de donner à l'embase 5 un diamètre tel que celle-ci puisse glisser sans jeu à l'intérieur du tube et de compter sur le matériau de remplissage 18, qui devrait être alors judicieusement choisi, pour, à la fois, immobiliser l'embase dans le tube et assurer l'étanchéité du boîtier 4. Il faut remarquer que, dans cette éventualité, l'anneau métallique $5_b$ ne serait plus nécessaire et que l'embase pourrait être entièrement en verre ou en un autre matériau isolant convenable.

Ces deux solutions ne sont en fait pas très satisfaisantes du point de vue fabrication comme du point de vue fiabilité.

Le mieux, si l'on se heurte à des difficultés pour réaliser l'ensemble tel qu'il est représenté sur la figure 3 est de renoncer à cette forme d'exécution au profit de la variante que montre la figure 4.

Dans cette variante le capot 4 du boîtier du résonateur et l'élément de protection 10 du circuit intégré 12 sont constitués par deux pièces distinctes. Le capot est d'un diamètre inférieur à celui de l'élément 10 et a son extrémité située du côté de l'embase 5 chassée à l'intérieur de l'élément tubulaire, jusqu'à une profondeur suffisante qui correspond sensiblement à la hauteur de cette embase.

Naturellement il n'est pas nécessaire que le métal ou l'alliage dont est fait l'élément 10 soit le même que celui du capot.

Par ailleurs le chassage peut être remplacé par un collage de l'élément 10 sur le capot 4, ce collage pouvant être assuré par le matériau 18 dont est rempli l'intérieur de cet élément.

En fait une variante du même genre a déjà été envisagée pour le cas d'un boîtier en verre et considérée alors comme moins intéressante que la solution du tube unique car cela rendrait l'ensemble plus fragile et sa fabrication plus compliquée. Ces inconvénients disparaissent pratiquement complètement lorsque le capot 4 et l'élément tubulaire 10 sont métalliques.

L'ensemble représenté sur la figure 4 peut être réalisé de deux manières.

La première consiste à utiliser un ruban métallique prédécoupé et à procéder de la façon décrite précédemment jusqu'au moment où l'on sépare le tout formé par le résonateur 2, l'embase 5 avec les broches $6_a$, $6_b$, le circuit intégré 12 et toutes les pattes de connexion $14_a$, $14_b$, 17, du ruban, puis à sceller le boîtier 1, c'est-à-dire chasser le capot sur l'embase, sous vide ou en atmosphère de gaz neutre. Il ne reste plus ensuite qu'à enfiler l'élément de protection 10 autour du circuit intégré et à le chasser sur la partie du capot 4 qui entoure l'embase 5 ou simplement positionner correctement cet élément si l'on opte pour la solution du collage, et à en remplir l'intérieur avec le matériau durcissable, isolant, opaque et éventuellement adhésif, choisi.

L'autre possibilité consiste à partir, d'une part, d'un résonateur déjà encapsulé dans un boîtier de type métallique, tel qu'il en existe actuellement et, d'autre part, d'un circuit intégré déjà muni de pattes de connexion, à coller ou souder les extrémités externes des broches de connexion qui font partie du boîtier sur celles des pattes qui sont prévues pour être reliées au résonateur, et à faire après la même chose que ce qui vient d'être dit pour l'élément de protection 10 et la matière de remplissage 18.

.

Les modes d'exécution qui ont été décrits jusqu'ici correspondent au cas où le résonateur doit être enfermé dans un boîtier étanche. Or, on connaît également des résonateurs qui, pour pouvoir jouer le rôle de capteurs pour lequel ils sont prévus, doivent au contraire être en contact avec le milieu qui les entoure. C'est le cas par exemple pour le résonateur qui fait l'objet de la demande de brevet européen publiée sous le numéro 0 099 330 et qui sert à mesurer la pression d'un gaz ou celui qui est décrit dans une autre demande de brevet européen, publiée sous le numéro 0 101 669, et qui permet de déterminer la teneur d'un gaz dans un mélange gazeux.

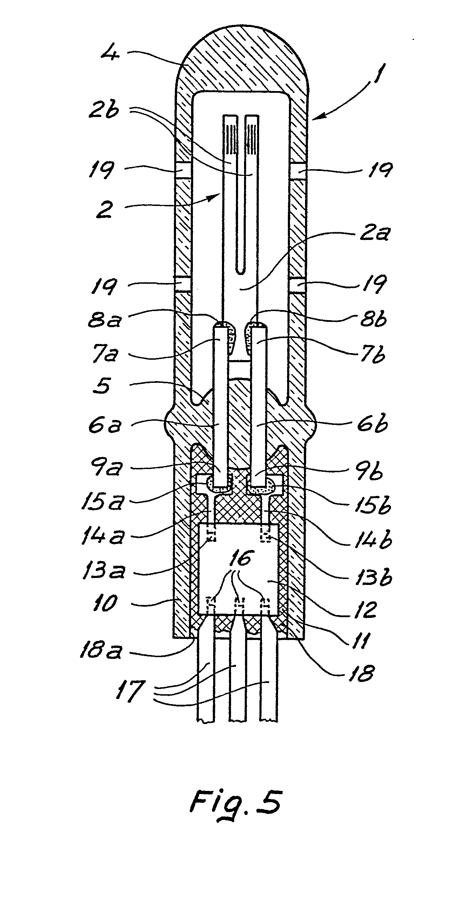

La figure 5 montre une forme possible de réalisation de l'ensemble selon l'invention, adaptée à ce genre de résonateur. Là encore les parties identiques ou correspondant à celles de l'ensemble représenté sur les figures 1 et 2 portent les mêmes repères.

En fait, on voit très vite que la seule différence avec le mode d'exécution des figures 1 et 2 est que le capot 4 est percé de trous 19, qui permettent de mettre l'intérieur du boîtier 1 en communication avec le milieu ambiant. Le capot 4 n'a donc plus ici pour fonction que de protéger le résonateur 2 et sa fixation aux extrémités internes $7_a$, $7_b$ des broches $6_a$, $6_b$.

Bien entendu cette modification, c'est-à-dire le perçage de trous dans le capot, pourrait aussi être apportée à la forme d'exécution de la figure 3 et à sa variante de la figure 4.

D'autre part, il est clair que l'invention n'est pas limitée aux exemples de mise en oeuvre qui viennent d'être décrits et aux variantes possibles qui ont déjà été signalées.

En particulier le résonateur 2 pourrait, d'une part, ne pas être un diapason mais avoir une autre forme, par exemple celle d'un barreau et, d'autre part, être supporté dans le boîtier par des moyens autres que les broches de connexion, auquel cas ces dernières n'auraient plus alors pour rôle que de relier électriquement le résonateur avec l'extérieur du boîtier.

On pourrait aussi très bien concevoir un ensemble avec deux résonateurs ou plus dans le boîtier. Une possibilité intéressante consisterait par exemple à réunir un diapason horloger et un capteur de température puisque l'on commence à utiliser les deux dans des montres où le second sert à compenser thermiquement les variations de fréquence du premier.

Par ailleurs, dans ce qui précède, il a toujours été dit ou sous-entendu que, dans le cas où le capot du boîtier et l'élément tubulaire de protection du circuit intégré étaient en deux parties, si l'un était en verre ou métallique l'autre l'était également. Or ceci n'est pas obligatoire et l'élément de protection peut très bien être constitué par un matériau très différent de celui du capot, en particulier une matière plastique.

On a dit également, à propos du mode de réalisation de la figure 3, qu'il était possible de donner à l'élément de protection ou à sa paroi interne une forme légèrement conique pour faciliter la fabrication de l'ensemble. En fait, dans certains cas et quel que soit le matériau dont est formé l'élément en question, il pourrait être avantageux de donner à ce dernier la forme d'un cône beaucoup plus évasé. Cela permettrait notamment de placer à l'intérieur un circuit intégré plus compliqué et ayant davantage de bornes d'entrée et de sortie, donc d'étendre le champ d'application de l'ensemble selon l'invention. A noter que cette forme conique n'exclut pas que l'élément de protection et le capot du boîtier soient réalisés en une seule pièce.

Enfin il faut signaler que l'on ne sortirait pas du cadre de l'invention si l'on supprimait carrément l'élément de protection qui n'est pas indispensable et si l'on se contentait de noyer toutes les parties de l'ensemble qui sont extérieures au boîtier du résonateur et qui ont intérêt à être protégées dans une masse de résine époxy opaque ou d'un matériau du même genre qui, de préférence, déborderait sur le capot du boîtier.

REVENDICATIONS

1. Ensemble comprenant un résonateur piézo-électrique; un boîtier tubulaire contenant ledit résonateur et comportant un capot, une embase sur laquelle est fixé ledit capot, et deux broches conductrices traversant ladite embase et ayant chacune une extrémité interne en liaison électrique avec le résonateur et une extrémité externe; et un circuit intégré ayant des plots de connexion d'entrée et de sortie dont deux sont reliés respectivement auxdites broches conductrices, caractérisé par le fait que le circuit intégré (12) est placé au voisinage de ladite embase (5) et monté sur lesdites extrémités externes ($9_a$, $9_b$) des broches conductrices ($6_a$, $6_b$).

2. Ensemble selon la revendication 1, caractérisé par le fait qu'il comporte en outre un élément tubulaire de protection (10) solidaire du boîtier (1) du résonateur (2), qui prolonge ledit capot (4) et à l'intérieur duquel est placé ledit circuit intégré (12).

3. Ensemble selon la revendication 2, caractérisé par le fait que ledit capot (4) et ladite embase (5) sont en verre.

4. Ensemble selon la revendication 3, caractérisé par le fait que ledit capot (4) est soudé par fusion sur ladite embase (5).

5. Ensemble selon la revendication 3 ou 4, caractérisé par le fait que ledit élément tubulaire (10) est également en verre et est fait d'une seule pièce avec ledit capot (4).

6. Ensemble selon la revendication 2, caractérisé par le fait que ledit capot (4) est métallique et chassé sur ladite embase (5).

7. Ensemble selon la revendication 6, caractérisé par le fait que ledit élément tubulaire (10) est également métallique.

8. Ensemble selon la revendication 7, caractérisé par le fait que ledit élément tubulaire (10) est fait d'une seule pièce avec ledit capot (4).

9. Ensemble selon l'une quelconque des revendications 2 à 8, caractérisé par le fait que la liaison entre lesdits deux plots de connexion ($13_a$, $13_b$) du circuit intégré (12) et les broches conductrices ($6_a$, $6_b$) est assurée par l'intermédiaire de deux pattes de connexion internes ($14_a$, $14_b$), chacune de ces pattes ayant une extrémité soudée sur l'un des deux plots de connexion et une autre extrémité sur laquelle est fixée l'extrémité externe ($9_a$, $9_b$) de l'une desdites broches conductrices.

10. Ensemble selon la revendication 10, caractérisé par le fait que les extrémités externes ($9_a$, $9_b$) des broches conductrices ($6_a$, $6_b$) sont fixées sur lesdites pattes de connexion internes ($14_a$, $14_b$) au moyen d'une colle conductrice.

11. Ensemble selon l'une quelconque des revendications 2 à 10, caractérisé par le fait qu'il comporte également des pattes de connexion externes (17) soudées sur les plots de connexion (16) du circuit intégré (12) autres que ceux ($13_a$, $13_b$) reliés aux broches conductrices ($6_a$, $6_b$) et qui sortent dudit élément tubulaire (10) du côté opposé à celui du boîtier (1) du résonateur (2).

12. Ensemble selon l'une quelconque des revendications 2 à 11, caractérisé par le fait que l'intérieur de l'élément tubulaire (10) est rempli d'un matériau isolant durcissable (18).

13. Ensemble selon la revendication 12, caractérisé par le fait que ledit matériau (18) est également opaque.

14. Ensemble selon la revendication 12 ou 13, caractérisé par le fait que ledit matériau (18) est une résine époxy.

15. Ensemble selon l'une quelconque des revendications précédentes, caractérisé par le fait que les extrémités internes ($7_a$, $7_b$) des broches conductrices ($6_a$, $6_b$) sont fixées sur le résonateur (2) et supportent celui-ci à l'intérieur du boîtier (1).

16. Ensemble selon la revendication 15, caractérisé par le fait que les extrémités internes ($7_a$, $7_b$) des broches conductrices ($6_a$, $6_b$) sont fixées sur le résonateur (2) au moyen d'une colle conductrice.

17. Ensemble selon l'une quelconque des revendications précédentes, caractérisé par le fait que le résonateur (2) est un résonateur à quartz en forme de diapason.

Fig.1

Fig.2

0167055

Fig. 3

Fig. 4

Fig. 5

## 0167055

Numero de la demande

**RAPPORT DE RECHERCHE EUROPEENNE**

Office européen
des brevets

EP 85 10 7523

## DOCUMENTS CONSIDERES COMME PERTINENTS

| Catégorie | Citation du document avec indication. en cas de besoin. des parties pertinentes | Revendication concernee | CLASSEMENT DE LA DEMANDE (Int Cl 4) |
|---|---|---|---|
| Y | PATENTS ABSTRACTS OF JAPAN, vol. 6, no. 28 (E-95)(906), 19 février 1982; & JP - A - 56 149 809 (MATSUSHITA DENKI SANGYO K.K.) 19-11-1981 * En entier * | 1,17 | H 03 H 9/05 G 04 F 5/06 |
| Y | FR-A-1 393 574 (SOCIETE D'ELECTRONIQUE ET DE PIEZO-ELECTRICITE) * En entier * | 1,17 | |
| A | GB-A-2 130 005 (SILCON ENTREPRISES) | 1,3,4, 6,15-17 | |
| A | DE-A-2 755 116 (STANDARD ELEKTRIK LORENZ) * Figure 1; page 8, lignes 5-26 * | 1,12-14 | |

DOMAINES TECHNIQUES
RECHERCHES (Int Cl 4)

H 03 H
G 04 F

Le présent rapport de recherche a éte établi pour toutes les revendications

| Lieu de la recherche LA HAYE | Date d'achevement de la recherche 01-10-1985 | Examinateur COPPIETERS C. |
|---|---|---|